Europäisches Patentamt

**European Patent Office**

**Office européen des brevets**

(11) Numéro de publication: **0 080 410**
**B1**

(12) **FASCICULE DE BREVET EUROPÉEN**

(45) Date de publication du fascicule du brevet:
**23.07.86**

(21) Numéro de dépôt: **82402101.8**

(22) Date de dépôt: **17.11.82**

(51) Int. Cl.⁴: **G 05 B 13/02,** G 01 R 29/00

(54) **Dispositif pour déterminer et suivre les coordonnées instantanées de l'extremum d'une courbe y = f(x), caractéristique d'un système comportant une entrée x et une sortie y.**

(30) Priorité: **20.11.81 FR 8121786**

(43) Date de publication de la demande:
**01.06.83 Bulletin 83/22**

(45) Mention de la délivrance du brevet:
**23.07.86 Bulletin 86/30**

(84) Etats contractants désignés:
**BE CH DE GB IT LI NL**

(56) Documents cité:
**EP-A-0 027 405**
**FR-A-2 386 854**
**US-A-4 143 314**

**AUTOMATISME, vol.13, no.3, mars 1968, Paris (FR), J.L. ABATUT et al.: "Classification des systèmes de régulation extrémale", pages 123-126**
**ELECTRONIC ENGINEERING, vol.37, mars 1965, Londres (GB), P. ZORKOCZY: "A simple automatic extremum seeker", pages 178,179**

**Le dossier contient des informations techniques présentées postérieurement au dépôt de la demande et ne figurant pas dans le présent fascicule.**

(73) Titulaire: **Lavergnat, Jacques, 10, rue Barrault, F-75013 Paris (FR)**
Titulaire: **Delahaye, Jean- Yves, 55, rue Jean Jaurès, F-92170 Vanves (FR)**

(72) Inventeur: **Lavergnat, Jacques, 10, rue Barrault, F-75013 Paris (FR)**
Inventeur: **Delahaye, Jean- Yves, 55, rue Jean Jaurès, F-92170 Vanves (FR)**

(74) Mandataire: **Mongrédien, André, c/o BREVATOME 25, rue de Ponthieu, F-75008 Paris (FR)**

LIBER, STOCKHOLM 1986

## Description

La présente invention a pour objet un dispositif pour déterminer et suivre les coordonnées instantanées de l'extremum d'une courbe $y = f(x)$, caractéristique d'un système comportant une entrée x et une sortie y.

Ce dispositif peut être utilisé notamment pour connaître la température et la densité électronique du plasma ionosphérique ou du plasma magnétosphérique.

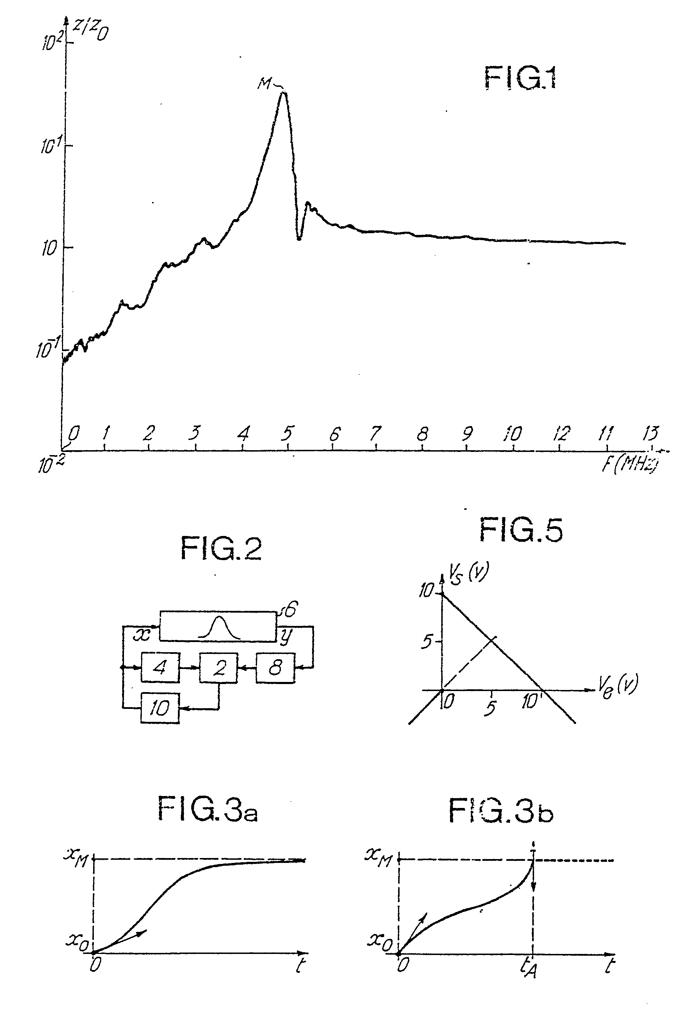

Dans le cadre de cette application, le système comportant une entrée x et une sortie y est constitué d'une sonde de mesure haute fréquence fournissant un signal électrique. Le signal électrique, dans le cas d'une sonde appropriée à la mesure de la densité électronique du plasma ionosphérique peut être par exemple illustré, comme schématisé sur la figure 1, par une courbe donnant les variations de l'impédance $z/z_0$ de la sonde en fonction de la fréquence f, exprimée en mégahertz. Comme on peut le constater, cette courbe présente un maximum principal M. La connaissance des coordonnées $x_M$, $y_M$ de ce maximum et notamment de l'abscisse $x_M$ (fréquence) permet de connaître directement la densité électronique du plasma ionosphérique. Cette détermination des coordonnées du maximum se fait par l'intermédiaire d'un circuit électronique connecté directement à l'entrée x et à la sortie y de la sonde de mesure et qui effectue un traitement du signal fourni par ladite sonde.

En général, la détermination des coordonnées de l'extremum, c'est-à-dire du maximum ou du minimum d'une courbe $y = f(x)$ se fait à l'aide d'un dispositif qui effectue un balayage des x. Malheureusement, ce type de détermination conduit à l'exploration de zones sans intérêt pour la connaissance des coordonnées de l'extremum, ce qui conduit à une perte de temps considérable. Ceci peut être très gênant dans le cas où l'extremum de la courbe $y = f(x)$ se déplace au cours du temps. Ceci est pratiquement toujours le cas, lorsque cette courbe est représentative de grandeurs physiques comme par exemple le signal électrique fourni par une sonde de mesure utilisée pour la détermination de la densité ou de la température électronique de l'ionosphère.

Dans le cas d'une évolution au cours du temps de l'extremum de la courbe $y = f(x)$, les dispositifs qui utilisent un balayage des x, étant donné leur temps de réponse, ne permettent pas, dans de nombreux cas, de déterminer les coordonnées de l'extremum avec une bonne précision et ne permettent pas de suivre l'évolution de ce dernier au cours du temps.

Afin de remédier à ces inconvénients, on a envisagé l'utilisation de dispositifs limitant le balayage des x aux valeurs proches de celles de l'abscisse $x_M$ de l'extremum. Ces dispositifs sont généralement connus sous le terme de dispositifs à asservissement extrémal. La description et le fonctionnement de ces dispositifs ont été faits dans un livre publié chez DUNOD automatique au troisième trimestre 1976 intitulé "Introduction aux systèmes asservis extrémaux et adaptatifs" et dont les auteurs sont P. DECAULNE, J.CH. GILLE et M. PELEGRIN.

Dans ce type de dispositif, la détermination des coordonnées $x_M$, $y_M$ de l'extremum d'une courbe $y = f(x)$ se fait en choisissant un point de coordonnées $x_0$, $y_0$ voisin de l'extremum et en modifiant la valeur de commande x, et par conséquent celle de y, au cours du temps jusqu'à ce que l'on obtienne $x - x_M = 0$. Ce processus est bien celui d'un asservissement.

Sur la figure 2, on a représenté un dispositif à asservissement extrémal du type à gradient fonctionnant sur ce principe. Ce dispositif comprend un circuit diviseur 2, comportant deux entrées et une sortie, un premier dérivateur 4, dont l'entrée est connectée à l'entrée x d'un système 6 (sonde de mesure) et dont la sortie est connectée à l'une des entrées du circuit diviseur 2; un second dérivateur 8, dont l'entrée est connectée à la sortie y du système 6 et dont la sortie est connectée à l'autre entrée du circuit diviseur 2; et un intégrateur 10 dont l'entrée est connectée à la sortie du circuit diviseur 2 et dont la sortie est connectée à l'entrée x du système 6.

Bien que fournissant de façon plus rapide que les dispositifs cités précédemment la valeur des coordonnées de l'extremum, et bien que permettant de suivre l'évolution de l'extremum au cours du temps, le temps de réponse de ce dispositif est encore trop important, lorsque l'extremum de la courbe se déplace à une vitesse élevée.

En outre, la reponse de ce dispositif, c'est à-dire les variations de x en fonction du temps, à partir d'une valeur $x_0$, ne permet d'atteindre la valeur $x_M$ que de façon asymptotique. Ceci est illustré par la courbe de la figure 3a.

Etant donné que $x_M$ est atteint de façon asymptotique, ce dispositif ne permet d'obtenir la valeur de l'abscisse $x_M$ de l'extremum avec une très bonne précision qu'au bout d'un temps infini. En revanche, la valeur de l'abscisse $x_M$ de l'extremum peut être obtenue au bout d'un temps très court mais avec une mauvaise précision.

L'invention a justement pour objet un dispositif pour déterminer et suivre les coordonnées instantanées de l'extremum d'une courbe $y = f(x)$, caractéristique d'un système comportant une entrée x et une sortie y, ce dispositif permettant de remédier à ces inconvénients et permettant notamment de déterminer et de suivre les coordonnées de l'extremum de façon précise et en un temps très court, c'est-à-dire de l'ordre de la milliseconde. Le dispositif est un dispositif à asservissement extrémal.

De façon plus précise, l'invention a pour, objet un dispositif comportant de façon connue:
- un premier dérivateur apte à engendrer une première tension et dont l'entrée est connectée à l'entrée x du système,
- un second dérivateur apte à engendrer une seconde tension et dont l'entrée est connectée à la sortie y du système,
- des moyens recevant les tensions engendrées par les deux dérivateurs pour fournir une tension fonction des tensions engendrées par lesdits dérivateurs, et

- un intégrateur dont l'entrée est connectée à la sortie desdits moyens et dont la sortie est connectée à l'entrée x du système,

et se caractérisant en ce que lesdits moyens sont constitués d'un circuit multiplicateur permettant de faire évoluer x vers $x_M$ à une vitesse proportionnelle au produit

$$\frac{dx}{dt} \cdot \frac{dy}{dt} \quad ,$$

l'intégrateur fournissant en sortie la coordonée instantanée $x_M$ de l'extremum au bout d'un temps fini ($t_A$).

Ce dispositif permet de déterminer de façon rapide et précise les coordonnées de l'extremum d'une courbe $y = f(x)$ car la valeur de $x_M$, contrairement au dispositif de l'art antérieur eat obtenue au bout d'un temps fini $t_A$ avec une très bonne précision. Ceci est illustré par la courbe de la figure 3b donnant les variations de x en fonction du temps, à partir d'une valeur $x_0$. Du point de vue mathématique, étant donné que la valeur de $x_M$ est atteinte avec une vitesse infinie (tangente verticale en $x_M$), ce point est appelé un point attracteur.

Selon un mode préféré de réalisation de l'invention, le dispositif comprend un amplificateur à gain discontinu dont l'entrée est connectée à la sortie du second dérivateur et dont la sortie est connectée à l'entrée du circuit multiplicateur, cet amplificateur étant apte à engendrer une tension $V_s$ qui, lorsque la tension $V_e$ engendrée par le second dérivateur est négative, est égale à $V_e$ et qui, lorsque ladite tension $V_e$ est positive est égale à $-V_e + C$, C étant une constante fonction des coefficients d'amplification du premier dérivateur, de l'intégrateur et du circuit multiplicateur.

Selon un autre mode préféré de réalisation de l'invention, le dispositif comprend, de plus, des moyens pour modifier la tension de décalage de l'intégrateur et dont l'entrée est connectée à la sortie du second dérivateur, cette modification consistant à appliquer, à l'entrée de l'intégrateur, périodiquement une tension $+\Delta W$ et une tension $-\Delta W$.

Selon une variante de ce mode de réalisation de l'invention, les moyens pour modifier la tension de décalage comprennent des moyens pour comparer la tension $V_e$, engendrée par le second dérivateur, à une tension $V_c$ qui est fonction des coefficients d'amplification premier dérivateur, de l'intégrateur et du circuit multiplicateur et des moyens pour appliquer, périodiquement après un temps $T_r$ la tension $+\Delta W$ et la tension $-\Delta W$, lorsque $V_e$ est au plus égale à $V_c$.

Selon un autre mode préféré de réalisation de l'invention, le dispositif comprend, de plus, des moyens pour initialiser la tension appliquée à l'entrée x du système. Ces moyens d'initialisation comprennent par exemple, des moyens permettant de régler la tension initiale et des moyens pour ramener la tension appliquée à l'entrée x du système à ladite tension initiale. Ceci peut être notamment utilisé lorsque la courbe $y = f(x)$ ne présente pas momentanément d'extremum.

D'autres caractéristiques et avantages de l'invention ressortiront mieux de la description qui suit, donnée à titre illustratif mais non limitatif, en référence aux figures annexées, sur lesquelles:

- la figure 1, déjà décrite, représente une courbe donnant les variations de l'impédance $z/z_0$ d'une sonde de mesure de la densité du plasma ionosphérique en fonction de la fréquence f, exprimée en mégahertz,
- la figure 2, déjà décrite, représente un schéma synoptique d'un dispositif de l'art antérieur, - la figure 3, déjà décrite, représente des courbes donnant les variations de x en fonction du temps; la figure 3a correspond à la réponse du signal d'un dispositif de l'art antérieur et la figure 3b à celle du dispositif de l'invention,
- la figure 4 représente un schéma synoptique du dispositif de l'invention,
- la figure 5 représente une courbe donnant les variations de la tension de sortie $V_s$ de l'amplificateur à gain discontinu, exprimée en volt, en fonction de la tension d'entrée $V_e$ de ce dernier, exprimée en volt, et
- la figure 6a et la figure 6b représentent respectivement les variations de la tension d'entrée $V_e$ de l'amplificateur à gain discontinu et de x exprimées en volt, en fonction du temps, exprimé en seconde.

Le dispositif permettant de déterminer et de suivre, conformément à l'invention, les coordonnées $x_M$, $y_M$ de l'extremum d'une courbe $y = f(x)$, caractéristique d'un système comportant une entrée x et une sortie y, tel que par exemple une sonde de mesure permettant de déterminer la densité ou la température électronique du plasma ionosphérique est un dispositif à asservissement extrémal. Dans la description qui va suivre, les différentes valeurs de x, ou tension de commande x, autour de l'extremum seront choisies dans un domaine compris entre -10V et +10V. Bien entendu, ceci n'est qu'un exemple de domaine des x.

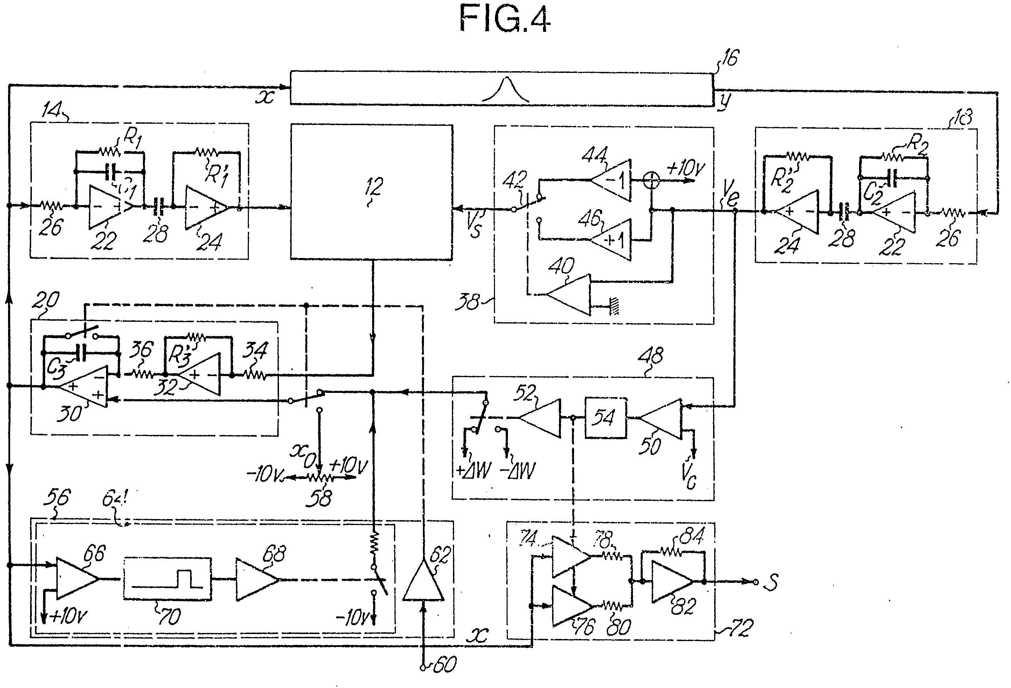

En se référant à la figure 4, le dispositif de l'invention comprend principalement un circuit multiplicateur 12, comportant deux entrées et une sortie; un premier dérivateur 14, dont l'entrée est connectée à l'entrée x d'un système 16, la sortie de ce dérivateur 14 étant connectée à l'une des entrées du circuit multiplicateur 12; un second dérivateur 18 dont l'entrée est connectée à la sortie y du système 16 et dont la sortie est connectée à l'autre entrée du circuit multiplicateur 12; et un intégrateur 20 dont l'entrée est connectée à la sortie du circuit multiplicateur 12 et dont la sortie est connectée à l'entrée x du système 16.

Comme on l'a dit précédemment, le fait de remplacer le circuit diviseur 2 du dispositif de l'art antérieur (voir figure 2) par un circuit multiplicateur 12, conformément à l'invention, permet d'obtenir, au bout d'un temps fini $t_A$ (figure 3b) et avec une bonne precision, les coordonnées instantanées $x_M$ et $y_M$ de l'extremum d'une courbe $y = f(x)$, correspondant, dans le cas d'une sonde de mesure, au signal électrique fourni par cette sonde (figure 1). Par ailleurs, le fait que la dérivée de x par rapport au temps $(\frac{dx}{dt})$ tend vers l'infini pour x égal $x_M$ permet d'obtenir une bonne performance en poursuite de l'extremum lorsque celui-ci varie dans le temps.

Comme schématisé sur cette figure, le premier et le deuxième dérivateurs 14 et 18 comprennent, en particulier, un circuit déphaseur, comportent un amplificateur opérationnel 22, une résistance 26 et un circuit RC, $R_1C_1$ pour le premier dérivateur et $R_2C_2$ pour le deuxième dérivateur, branché entre l'entrée et la sortie dudit amplificateur opérationnel 22, et un circuit derivateur proprement dit, comportant un amplificateur opérationnel 24, un condensateur 28 et une résistance R', $R'_1$ pour le premier dérivateur et $R'_2$ pour le deuxième dérivateur, branchée entre l'entrée et la sortie dudit amplificateur opérationnel 24. L'entrée du circuit dèphaseur est reliée à l'entrée x du système 16, par l'intermédiaire de la résistance 26, et la sortie de ce circuit déphaseur est reliée à l'entrée du circuit dérivateur proprement dit, par l'intermédiaire du condensateur 28.

Il est à noter que la constante de temps $(R_2C_2)$ introduite par le circuit déphaseur du deuxième dérivateur 18 correspond en fait à celle introduite par un filtre passe-bas placé à la sortie du système 16, lorsque celui-ci correspond à une sonde de mesure permettant de déterminer la densité ou la température électronique du plasma ionosphérique. Ce filtre est nécessaire pour réduire les bruits captés par la sonde de mesure. Pour donner un ordre de grandeur, cette constante de temps est prise égale à 1ms.

En ce qui concerne la constante de temps $(R_1C_1)$ introduite par le circuit déphaseur du premierv. dérivateur 14, celle-ci est prise égale a $2.10^{-4}$s.

Par ailleurs, les produits $R'_1,C_{28}$ et $R'_2C_{,28}$, caractéristiques des dérivateurs proprement dits, sont pris égaux à 10 ms, $C_{28}$ représentant la valeur de la capacite des condensateurs 28.

De même, l'intégrateur 20 comprend un circuit intégrateur proprement dit, comportant un amplificateur opérationnel 30, une résistance 36 et un condensateur $C_3$ branché entre l'entrée négative et la sortie dudit circuit intégrateur 30, et un circuit déphaseur, comportant un amplificateur opérationnel 32, une résistance 34 et une résistance $R'_3$ branchée entre la sortie et l'entrée. dudit amplificateur opérationnel 32. L'entrée du circuit déphaseur est reliée à la sortie du circuit multiplicateur 12, par l'intermédiaire de la résistance 34, et la sortie de ce circuit déphaseur à l'entrée négative de l'amplificateur opérationnel 30 du circuit intégrateur proprement dit, par l'intermédiaire de la résistance 36. Le produit $R_{36}C_3$, caractéristique de l'intégrateur proprement dit, est pris par exemple égal à 5 ms, $R_{36}$ représentant la valeur de la résistance 36.

Afin de tenir compte des dérives des différents amplificateurs opérationnels constituant notamment les dérivateurs 14 et 18 ainsi que des constantes de temps de ces dérivateurs, introduites notamment par les circuits de déphasage, le dispositif de l'invention doit être muni d'un amplificateur à gain discontinu 38 dont l'entrée est connectée à la sortie du second dérivateur 18 et dont la sortie est connectée à l'entrée du circuit multiplicateur 12.

Cet amplificateur à gain discontinu 38 permet d'engendrer une tension de sortie $V_s$ telle que, lorsque la tension d'entrée $V_e$ de cet amplificateur délivrée par le second dérivateur 18 est négative, on ait $V_s = V_e$ et, telle que lorsque cette tension $V_e$ est positive, on ait $V_s = -V_e + C$, C étant une constante fonction des paramètres caractéristiques du premier dérivateur 14, de l'intégrateur 20 et du circuit multiplicateur 12. Ces paramètres représentent principalement les coefficients d'amplification des différents circuits constituant les dérivateurs 14 et 18 et le circuit multiplicateur 12. A titre d'exemple, la constante C est prise égale à 10V pour des valeurs de x variant de -10V à +10V.

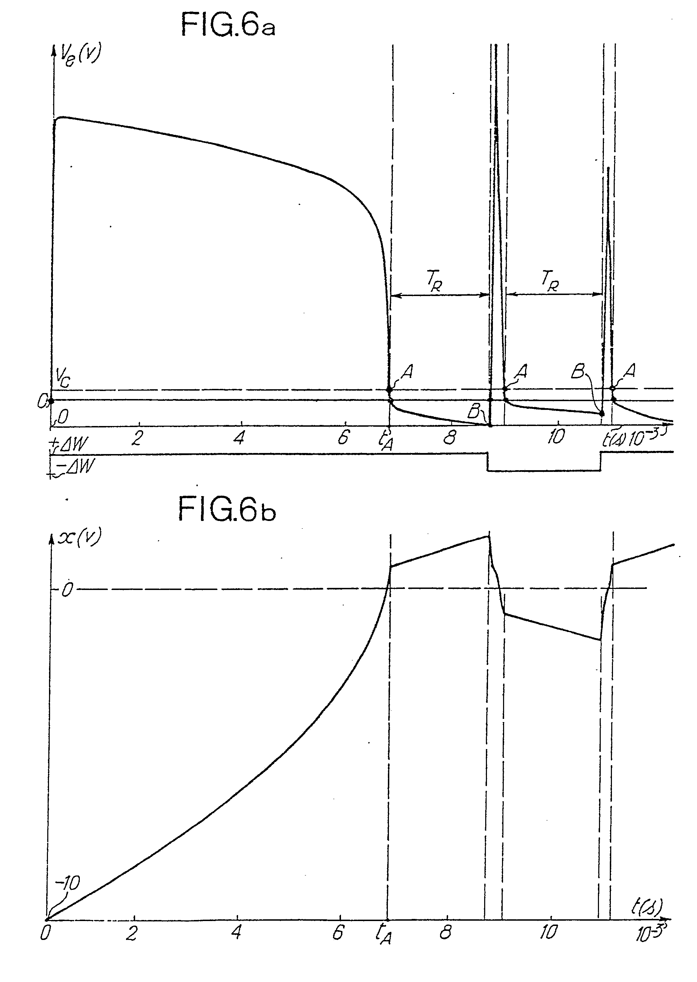

Sur la figure 5, on a représenté la courbe donnant la tension de sortie $V_s$ de l'amplificateur à gain discontinu exprimée en volt, en fonction de la tension d'entrée $V_e$ dudit amplificateur, exprimée en volt, les variations de $V_s$ en fonction de $V_e$ étant données dans un domaine de tension variant entre -10V et +10V.

Cet amplificateur à gain discontinu 38 permet d'atteindre avec une grande vitesse l'extremum de la courbe $y = f(x)$ et de réduire cette vitesse lorsque celui-ci est dépassé. Cet amplificateur 38 comprend par exemple un circuit comparateur 40 permettant de comparer la tension d'entrée $V_e$. dudit amplificateur une tension nulle ou par rapport à la masse. Ce comparateur 40 commande un interrupteur 42, qui peut être par exemple une porte analogique et qui permet de connecter l'entrée du circuit multiplicateur 12 soit, à la sortie d'un amplificateur opérationnel inverseur 44 soit, à la sortie d'un amplificateur opérationnel non-inverseur 46.

Le dispositif selon l'invention décrit jusqu'à présent, permettait essentiellement d'atteindre et de déterminer les coordonnées de l'extremum de la courbe $y = f(x)$.

Le dispositif peut donc être utilisé pour determiner de façon précise et rapide les coordonnées de l'extremum d'une courbe $y = f(x)$ dans le cas où celui-ci ne varie pas au cours du temps.

Afin de suivre l'évolution de l'extremum au cours du temps, lorsque celui-ci varie, le dispositif de l'invention doit être muni d'un système 48 permettant de modifier la tension de décalage de l'intégrateur 20. L'entrée de ce système 48 est connectée à la sortie du deuxième dérivateur 18 et la sortie de ce système 48 à l'entrée du circuit intégreteur proprement dit constituant l'intégrateur 20. De préférence, la sortie du système 48 est connectée à l'entrée positive de l'amplificateur opérationnel 30 constituant le circuit intégrateur proprement dit. Ce système 48 permet de modifier la tension de décalage de l'intégrateur 20 en appliquant notamment à l'entrée positive de l'amplificateur opérationnel 30 une tension ΔW passant de façon périodique de +ΔW à -ΔW.

Ce système 48 est principalement constitué d'un comparateur 50 permettant de comparer la tension $V_e$, fournie par le second dérivateur 18, à une tension $V_c$ qui est fonction des paramètres caractéristiques du premier dérivateur 14, de l'intégrateur 20 et du circuit multiplicateur 12. Lorsque la tension $V_e$ est au plus égale à la tension $V_c$, le comparateur 50 donne l'ordre d'appliquer notamment à l'entrée positive de l'amplificateur opérationnel 30 une tension égale, soit à +ΔW, soit à -ΔW, cette tension étant engendrée par un amplificateur opérationnel 52. L'application de cette tension est effectuée après un temps $T_r$ engendré par une cellule à retard 54, qui peut être par exemple une porte à hystérésis associée à un circuit RC, connectée entre la sortie du comparateur 50 et l'entrée de l'amplificateur opérationnel 52.

Sur la figure 6a, on a représenté les variations de la tension $V_e$ engendrée par le second dérivateur 18, exprimée en volt, en fonction du temps t, exprimé en seconde, les variations de la tension $V_e$ au cours du temps sont fonction de la tension de décalage ΔW appliquée à l'entrée de l'intégrateur 20. Les points portant la référence A correspondent à l'ordre donné par le comparateur 50 à l'amplificateur 52, pous appliquer la tension ΔW à l'entrée positive de l'amplificateur opérationnel 30 du circuit intégrateur proprement dit, et les points B correspondent à l'exécution de cet ordre, cette exécution ayant lieu après le temps $T_r$ engendré par la cellule à retard 54. A titre d'exemple, la tension $V_c$ est prise égale à 250 mV, la tension ΔW à 50 mV et le temps $T_r$ à 2 ms.

Sur la figure 6b, en corrélation avec la figure 6a, cn a représenté les variations de x, exprimées en volt, en fonction du temps, exprimé en seconde, la droite correspondant à x = 0 représentant la valeur de l'abscisse $x_M$ de l'extremum de la courbe y = f(x).

Selon l'invention, le dispositif peut être muni, comme représenté sur la figure 4, d'un système 56 permettant d'initialiser la tension appliquée à l'entrée x du système 16. L'initialisation peut être obtenue simplement en court-circuitant le condensateur $C_3$ du circuit intégrateur proprement dit de l'intégrateur 20 qui fournit la tension de commande x. La valeur initiale de x, soit $x_0$ est alors réglée par un potentiomètre 58. En général $x_0$ est égal à -10V. La remise à la valeur initiale $x_0$ peut être faite, soit manuellement, soit commandée par un signal appliqué par une borne portant la référence 60 et pouvant être amplifié à l'aide d'un amplificateur opérationnel 62.

Le système d'initialisation 56 peut aussi être muni d'un dispositif de blocage 64 permettant de ramener la valeur de commande x à la valeur initiale $x_0$, lorsque la courbe y = f(x) ne présente pas momentanément d'extremum dans le domaine des x variant entre -10V et +10V ou lorsque la pente de la courbe y = f(x) est beaucoup trop faible, c'est-à-dire inférieure à $10^{-2}$. Dans ces deux cas, le dispositif de l'invention reste bloqué à la valeur de x = +10V.

Ce dispositif de déblocage 64 comprend un comparateur 66 permettant de comparer la tension de commande x par rapport à 10V et commandant un amplificateur opérationnel 68 fournissant en même temps que la tension de décalage ΔW de l'intégrateur 20 une tension négative elevée de façon à ramener la valeur de x à la valeur initiale de -10V. Ce dispositif de déblocage 64 comprend de plus un circuit de retard 70 permettant d'appliquer la forte tension negative au bout d'un temps $t_b$. A titre d'exemple, ce temps $t_b$ est pris égal à 10s.

Afin d'affiner la valeur de l'abscisse $x_M$ de l'extremum de la courbe y = f(x) le dispositif de l'invention peut être muni d'un dispositif d'échantillonnage 72. L'une des entrées de ce dispositif d'échantillonnage 72 est connectée à la sortie de la cellule à retard 54 du système 48, commandant la tension de décalage de l'integrateur 20, et l'autre entrée de ce dispositif d'échantillonnage est connectée a l'entrée x du système 16.

Ce dispositif d'échantillonnage 72 comprend un amplificateur opérationnel 74 dont l'une des entrées est connectée à l'une des entrées d'un autre amplificateur opérationnel 76 et dont la sortie est connectée à la sortie du deuxième amplificateur opérationnel 76 par l'intermédiaire de deux résistances 78 et 80. Le signal de sortie des deux amplificateurs opérationnels 74 et 76 (pont commun des résistances) est envoyé sur un sommateur, comportant un amplificateur opérationnel 82 et une résistance 84 branchée entre l'entrée et la sortie de l'amplificateur opérationnel 82. Ce sommateur permet de calculer la demi-somme des tensions de sortie des deux amplificateurs opérationnels 74 et 76. La valeur affinée de l'abscisse $x_M$ de l'extremum de la courbe y = f(x) ainsi que son évolution au cours du temps sont obtenues à la sortie S du dispositif d'échantillonnage 72, cest-àdire à la sortie du dispositif de l'inventation.

Le dispositif conformément à l'invention a été testé pour différents types de courbes y = f(x) et notamment avec des courbes de forme très pointue ou très large. La valeur de l'extremum de ces différentes courbes a été obtenue avec une précision relative inférieure à 0,01% du domaine -10V +10V, lorsque l'extremum ne varie pas, et à 0,2% de ce même domaine, lorsque l'extremum varie avec une vitesse en x de 200 V/s, et ce en un temps de l'ordre de la milliseconde. Ce dispositif permet de suivre la valeur des coordonnées de l'extremum, lorsque celui-ci varie aussi bien en ordonnées qu'en abscisses, avec une vitesse en x

de l80V/s et en y de 60 V/s, et avec une vitesse en x de 300V/s lorsque l'extremum varie uniquement suivant le domaine des x.

Il est à noter que les valeurs des différents paramètres, indiquées précédemment, ne sont données qu'à titre d'exemple, et que les performances du dispositif de l'invention sont fonction des paramètres choisis.

Par ailleurs, ce dispositif a été testé avec des courbes présentant des extremum secondaires (figure 1). Dans ce cas, le temps pour déterminer la valeur de l'extremum principal s'est révélé beaucoup plus court que celui nécessaire avec les dispositifs de l'art antérieur.

## Revendications

1. Dispositif pour déterminer et suivre au cours du temps au moins une des coordonnées instantanées $(x_M, y_M)$ de l'extremum d'une courbe $y = f(x)$ caractéristique d'un système (16) comportant une entrée x et une sortie y, ce dispositif comportant:
- un premier dérivateur (14) apte à engendrer une première tension et dont l'entrée est connectée à l'entrée x du système (16),
- un second dérivateur (18) apte à engendrer une seconde tension et dont l'entrée est connectée à la sortie y du système (16),
- des moyens (12) recevant les tensions engendrées par les deux dérivateurs (14, 18) pour fournir une tension fonction des tensions engendrées par lesdits dérivateurs, et
- un intégrateur (20) dont l'entrée est connectée à la sortie desdits moyens (12) et dont la sortie est connectée à l'entrée x du système (16), caractérisé en ce que lesdits moyens sont constitués d'un circuit multiplicateur permettant de faire évoluer x vers $x_M$ à une vitesse proportionnelle au produit

$$\frac{dx}{dt} \cdot \frac{dy}{dt} \; ,$$

l'intégrateur (20) fournissant en sortie la coordonnée instantanée $x_M$ de l'extremum au bout d'un temps fini $(t_A)$.

2. Dispositif selon la revendication 1, caractérisé en ce qu'il comprend, en outre, un amplificateur à gain discontinu (38) dont l'entrée est connectée à la sortie du second dérivateur (18) et dont la sortie est connectée à l'entrée du circuit multiplicateur (12), cet amplificateur étant apte à engendrer une tension $V_s$ qui, lorsque la tension $V_e$ engendrée par le second dérivateur (18) est négative, est égale à $V_e$ et qui, lorsque ladite tension $V_e$ est positive, est égale à $-V_e + C$, C étant une constante fonction des coefficients d'amplification du premier dérivateur (14), de l'intégrateur (20) et du circuit multiplicateur (12).

3. Dispositif selon l'une quelconque des revendications 1 et 2, caractérisé en ce qu'il comprend, de plus, des moyens (48) pour modifier la tension de décalage de l'intégrateur (20) et dont l'entrée est connectée à la sortie du second dérivateur (18), cette modification consistant à appliquer, à l'entrée de l'intégrateur, périodiquement une tension $+\Delta W$ et une tension $-\Delta W$.

4. Dispositif selon la revendication 3, caractérisé en ce que les moyens pour modifier la tension de décalage comprennent des moyens (50) pour comparer la tension $V_e$, engendrée par le second dérivateur (18), à une tension $V_c$ qui est fonction des coefficients d'amplification du premier dérivateur (14), de l'intégrateur (20) et du circuit multiplicateur (12), et des moyens (52, 54) pour appliquer périodiquement après un temps $T_r$, la tension $+\Delta W$ et la tension $-\Delta W$, lorsque $V_e$ est au plus égale à $V_c$.

5. Dispositif selon l'une quelconque des revendications 1 à 4, caractérisé en ce qu'il comprend, de plus, des moyens (56) pour initialiser la tension appliquée à l'entrée x du système (16), ces moyens comportant des moyens (58) permettant de régler la tension initiale et des moyens (60, 62, 64) pour ramener la tension appliquée à l'entrée x du système à ladite tension initiale.

## Patentansprüche

1. Anordnung zum Bestimmen und, im Verlauf der Zeit, Nachlaufen wenigstens einer der Augenblickskoordinaten $(x_M, y_M)$ eines Extremwertes einer Kurve $y = f(x)$, die für ein System (16), das einen Eingang x und einen Ausgang y hat, charakteristisch ist, die Anordnung enthaltend:
- ein erstes Differenzierglied (14), das dazu eingerichtet ist, eine erste Spannung zu erzeugen und dessen Eingang mit dem Eingang x des Systems (16) verbunden ist,
- ein zweites Differenzierglied (18), das dazu eingerichtet ist, eine zweite Spannung zu erzeugen und dessen Eingang mit dem Ausgang y des Systems (16) verbunden ist,
- Einrichtungen (12), die die von den zwei Differenziergliedern (14, 18) erzeugten Spannungen empfangen, um eine Spannung als Funktion der von den genannten Differenziergliedern erzeugten Spannungen zu liefern, und
- ein Integrierglied (20), dessen Eingang mit dem Ausgang der genannten Einrichtungen (12) verbunden ist und dessen Ausgang mit dem Eingang x des Systems (16) verbunden ist, dadurch gekennzeichnet, daß die genannten Einrichtungen von einem Multiplizierkreis gebildet sind, der es erlaubt, x gegen $x_M$ mit einer Geschwindigkeit zu entwickeln, die proportional dem Produkt

$$\frac{dx}{dt} \cdot \frac{dy}{dt}',$$

ist wobei das Integrier lied (20) am Aus an die Augenblickskoordinate ($x_M$) des Extremwertes am Ende einer bestimmten Zeit ($t_A$) liefert.

2. Anordnung nach Anspruch 1, dadurch gekennzeichnet, daß sie weiterhin einen Verstärker mit unstetiger Verstärkung (38) enthält, dessen Eingang mit dem Ausgang des zweiten Differenziergliedes (18) verbunden ist und dessen Ausgang mit dem Eingang des Multiplizierkreises (12) verbunden ist, wobei dieser Verstärker dazu eingerichtet ist, eine Spannung $V_s$ zu liefern, die, wenn die von dem zweiten Differenzierglied (18) erzeugte Spannung $V_e$ negativ ist, gleich $V_e$ ist, und die, wenn die genannte Spannung $V_e$ positiv ist, gleich $-V_e + C$ ist, wobei C eine konstante Funktion der Verstärkungsfaktoren des ersten Differenziergliedes (14), des Integriergliedes (20) und des Multiplizierkreises (12) ist.

3. Anordnung nach einem der Ansprüche 1 und 2, dadurch gekennzeichnet, daß sie darüberhinaus Einrichtungen (48) zum Modifizieren der Versatzspannung des Integriergliedes (20) aufweist, deren Eingang mit dem Ausgang des zweiten Differenziergliedes (18) verbunden ist, wobei diese Modifikation darin besteht, an den Eingang des Integriergliedes periodisch eine Spannung $+ \Delta W$ und eine Spannung $- \Delta W$ anzulegen. 4. Anordnung nach Anspruch 3, dadurch gekennzeichnet,daß die Einrichtungen zum Modifizieren der Versatzspannung (50) enthalten, um die vom zweiten Differenzierglied (18) erzeugte Spannung V mit einer Spannung V zu vergleichen, die eine Funktion der Verstärkungsfaktoren des ersten Differenziergliedes (14), des Integriergliedes (20) und des Multiplizierkreises (12) ist, und Einrichtungen (52, 54) enthält, um periodisch nach einer Zeit $T_r$ die Spannung $+ \Delta W$ und die Spannung $- \Delta W$ anzulegen, wenn $V_e$ höchstens gleich $V_c$ ist.

5. Anordnung nach einem der Ansprüche 1 bis 4, dadurch gekennzeichnet, daß sie darüberhinaus Einrichtungen (56) zum Initialisieren der dem Eingang x des Systems (16) zugeführten Spannung enthält, wobei diese Einrichtungen eine Einrichtung (58), die eine Regelung der Anfangsspannung erlaubt, und Einrichtungen (60, 62, 64) enthalten, um die dem Eingang x des Systems zugeführte Spannung an die genannte Anfangsspannung heranzuführen.

**Claims:**

1. Apparatus for determining and following over a period at least one of the instantaneous coordinates ($x_M$, $y_M$) of the extreme of a function y = f (x) which is a characteristic of a system (16) having an input x and an output y, said apparatus comprising:
- a first differentiator (14) adapted to generate a first potential and whose input is connected to the input x of system (16),
- a second differentiator (18) adapted to generate a second potential, and whose input is connected to the output y of the system (16),
- means (12) receiving the potentials generated by the two differentiators (14,18) to provide a potential which is a function of the potentials generated by said differentiators, and
- an integrator (20) whose input is connected to the output of said means (12) and whose output is connected to the input x of the system (16),
- characterized in that in that said means comprise a multiplier circuit permitting evolution of x towards $x_M$ at a speed proportional to the product

$$\frac{dx}{dt} \cdot \frac{dy}{dt} ;$$

the integrator (20) providing as output the instantaneous coordinate $x_M$ of the extreme at the end of a finite time ($t_A$).

2. Apparatus according to Claim 1, characterized in that it additionally comprises a discontinuousgain amplifier (38) whose input is connected to the output of the second differentiator (18) and whose output is connected to the input of the multiplier circuit (12), said amplifier being adapted to generate a potential $V_s$ which, when the potential $V_e$ generated by the second differentiator (18) is negative, is equal to $V_e$, and which, when said potential $V_e$ is positive, is equal to $- V_e + C$, C being a constant function of the amplification coefficient of the first differentiator (14), of the integrator (20) and of the multiplier circuit (12).

3. Apparatus according to either of Claims 1 and 2 characterized in that it additionally comprises means (48) for modifying the shift potential of the integrator (20) and whose input is connected to the output of the second differentiator (18), said modification consisting in applying a potential $+ \Delta W$ and a potential $- \Delta W$ periodically to the input of the integrator.

4. Apparatus according to Claim 3, characterized in that the means for modifying the shift potential comprise means (50) for comparing the potential $V_e$ generated by the second differentiator (18) of the potential $V_c$ which is a function of the amplification coefficients of the first differentiator (14), of the integrator (20) and of the multiplier circuit (12), and means (52, 54) for periodically applying the potential $+ \Delta W$ and potential $- \Delta W$ after a time $T_r$ while $V_e$ is at least equal to $V_c$.

5. Apparatus according to any one of Claims 1 to 4, characterized in that it additionally comprises means (56) for initialising the potential applied to the input x of the system (16), said means comprising means (58) for controlling the initial potential and means (60, 62, 64) for restoring the potential applied to the input x of the system to said initial potential.

FIG.1

FIG.2

FIG.5

FIG.3a

FIG.3b

# FIG.4

0 080 410

# FIG.6a

# FIG.6b